# EUROPÄISCHE PATENTANMELDUNG

(11) **EP 1 136 830 A1**
(43) Veröffentlichungstag der Anmeldung: **26.09.2001**
(21) Anmeldenummer: 00106268.6
(22) Anmeldetag: 22.03.2000
(51) Int. Cl.: G01R 29/027, G01R 23/15

(54) **Frequenzsensor für digitale Signale und Verfahren zur Frequenzüberwachung eines digitalen Signales**

(71) Anmelder: Infineon Technologies AG, 81669 München (DE)
(72) Erfinder: Kniffler, Oliver, 81737 München (DE); Guo, Shwei, Dr., 81737 München (DE); Nolles, Jürgen, 81541 München (DE)
(74) Vertreter: Epping, Wilhelm, Dipl.-Ing.

(57) **Zusammenfassung**

Die Erfindung betrifft einen Frequenzsensor und ein Verfahren zur Frequenzüberwachung digitaler Signale, bei denen die Periodendauer (T_{IN}) eines Eingangssignales (IN) ausgewertet wird. Durch einen von einem internen Taktsignal (int_clk) weitergeschalteten Zähler (BC) ist eine Zeitbasis bereitgestellt. Die minimale und maximale Frequenz (Fₘᵢₙ, Fₘₐₓ) eines erlaubten Frequenzbereiches werden anhand der entsprechenden Periodendauer (Tₘᵢₙ, Tₘₐₓ) festgestellt und durch zwei festlegbare Werte (n_{L}, n_{H}) bestimmt, die mit der Periodendauer Tclk mulipliziert die minimale und maximale Periodendauer (Tₘᵢₙ, Tₘₐₓ) des Eingangssignales (T_{IN}) ergeben. Ein Zustandsspeicher (FSM) des Frequenzsensors weist drei Zustände auf, wobei neben einem Normalzustand (0) ein Alarmzustand (1_{L}) für eine zu geringe Frequenz und ein Alarmzustand (1_{H}) für eine zu hohe Frequenz vorgesehen sind. In den Zustand (1_{L}) wird umgeschaltet, wenn eine Zählvariable den Wert (n_{L}) erreicht wird. In den Zustand (1_{H}) wird übergegangen, wenn die Zählvariable kleiner als (n_{H}) ist und eine ansteigende Flanke detektiert wurde. Bei entweder jeweils ansteigender oder abfallender Flanke wird der Zähker (BC) zurückgesetzt.

## Beschreibung

Frequenzsensor für digitale Signale und Verfahren zur Frequenzüberwachung eines digitalen Signales

Die Erfindung betrifft einen Frequenzsensor für digitale Signale, der ausgewertet, ob die Frequenz eines Eingangssignales größer oder kleiner als ein erlaubter Frequenzbereich ist. Außerdem betrifft die Erfindung ein Verfahren zur Frequenzüberwachung eines digitalen Signales.

Häufig müssen periodische digitale Signale, beispielsweise ein Taktsignal für eine elektronische Schaltung, dahingehend überwacht werden, ob sie in einem vorgegebenen Frequenzbereich liegen. Die erlaubte Frequenz liegt dabei zwischen einem unteren Grenzwert Fₘᵢₙ und einem oberen Frequenzwert Fₘₐₓ. Üblicherweise sind Frequenzsensoren als analoge Schaltungen aufgebaut. Die Grenzwerte Fₘᵢₙ und Fₘₐₓ hängen daher stark von den Herstellungstoleranzen der Schaltkreise ab. Außerdem ist es oft gewünscht, die Grenzwerte je nach Anwendungsfall einstellen zu können, ohne dabei Änderungen an der Schaltungsanordnung bzw. dem Chipdesign vorzunehmen. Bei analog aufgebauten Frequenzsensoren ist dies jedoch nicht möglich.

Aufgabe der vorliegenden Erfindung ist es daher, einen Frequenzsensor für digitale Signale aufzuzeigen, der eine einfache Möglichkeit der Programmierung vorsieht. Außerdem soll ein Verfahren zur Frequenzüberwachung angegeben werden.

Diese Aufgabe wird gelöst durch einen Frequenzsensor für digitale Signale mit einem Flankendetektor, dessen Eingang mit einem Anschluß für ein Filter-Eingangssignal mit zwei möglichen Pegeln verbunden ist, einem Zähler, der Eingänge für ein Taktsignal und ein Resetsignal aufweist, einem drei Zustände aufweisenden Zustandsspeicher, der mit dem Zähler und dem Ausgang des Flankendetektors verbunden ist, wobei durch die Zustände des Zustandsspeichers Ausgangssignale des Filtersensors bestimmt sind, wobei der Zustandspeicher bei Erreichen eines ersten festlegbaren Wertes, der in Verbindung mit der Periodendauer des Taktsignals eine maximalen Pulsdauer beschreibt, einen eine Unterschreitung eines erlaubten Frequenzbereich markierenden Zustand einnimmt, bei steigender/fallender Flanke des Eingangssignales und einem Zählerstand, der unterhalb eines zweiten festlegbaren Wertes liegt, der in Verbindung mit der Periodendauer des Taktsignals eine minimale Pulsdauer beschreibt, einen eine Überschreitung des erlaubten Frequenzbereich markierenden Zustand einnimmt und in anderen Fällen im neutralen Zustand verleibt, und wobei bei einer steigenden/fallenden Flanke ein Rücksetzsignal an dem Zähler anliegt.

Die Lösung für den zweiten Teil der Aufgabe ist ein Verfahren zur Frequenzüberwachung eines digitale Signales bei dem eine Zählvariable bei einer ansteigenden Flanke eines Eingangssignales auf einen Startwert gesetzt wird und anschließend die Zählvariable durch ein vorgegebenes Taktsignal schrittweise erhöht/erniedrigt wird, bei Erreichen eines ersten festlegbaren Wertes der Zählvariablen eine erste Ausgangsvariable auf einen eine zu niedrige Frequenz des Eingangssignales markierenden Wert gesetzt wird, bei einer ansteigenden Flanke des Eingangssignales die erste oder eine zweite Ausgangsvariable auf einen eine zu hohe Frequenz des Eingangssignales markierenden Wert gesetzt wird, wenn die Zählvariable kleiner als ein zweiter festlegbarer Wert ist, wobei der zweite festlegbare Wert kleiner als der erste festlegbare Wert ist.

Die Festlegung der Grenzwerte eines erlaubten Frequenzbereiches geschieht über das Festlegen des ersten und zweiten festlegbaren Wertes. Eine weitere Einstellmöglichkeit, die beide Grenzwerte verändert, ist die Änderung der Frequenz des Taktsignales. Abgesehen von den festlegbaren Werten und der Taktfrequenz ist der erfindungsgemäße Frequenzsensor völlig unabhängig von den Bauteilwerten der Einzelelemente. Das erfindungsgemäße Verfahren ist sowohl für sehr kleine Frequenzen als auch für sehr große Frequenzen anwendbar. Der Frequenzsensor kann ohne Änderungen der Struktur in verschiedensten Anwendungsfällen eingesetzt werden.

Weitere Einzelheiten und Ausgestaltungen der Erfindung sind in den Unteransprüchen angegeben.

Die Erfindung wird nachfolgend an einem Ausführungsbeispiel anhand der Zeichnungen näher erläutert. Es zeigt:
Figur 1 ein Ablaufdiagramm eines erfindungsgemäßen Verfahrens,
Figur 2 ein Zustandsdiagramm des erfindungsgemäßen Verfahrens sowie des Frequenzsensors,
Figur 3 ein Blockschaltbild eines erfindungsgemäßen Frequenzsensors und
Figur 4 die zeitlichen Signalverläufe der in dem Frequenzsensor von Figur 4 auftretenden Signale.

Zwei Grenzwerte Fₘᵢₙ und Fₘₐₓ beschränken den Frequenzbereich, in dem ein zulässiges Eingangssignal IN liegt. Übertragen auf den zeitlichen Verlauf des Eingangssignales IN bedeutet dies, daß eine Periodendauer Tₘᵢₙ = 1/Fₘᵢₙ nicht überschritten und eine Periodendauer Tₘₐₓ = 1/Fₘₐₓ nicht unterschritten werden darf. Ist dies der Fall, so ist die Frequenz entweder zu niedrig oder zu hoch. Zur Messung der Periodendauer Tₘᵢₙ und Tₘₐₓ des Eingangssignales IN kann die Zeit zwischen zwei jeweils ansteigenden oder abfallenden Flanken herangezogen werden. Zur Bestimmung der Periodendauer wird die Periodendauer T_{int_clk} eines internen Taktsignales int_clk herangezogen. Die Periodendauer Tₘᵢₙ entspricht etwa nL ^{*} T_{int_clk}. Entsprechend gilt Tₘₐₓ ≈ n_{H} ^{*} T_{int_clk}.

Die Frequenz des internen Taktsignales int_clk ist dabei wesentlich höher als die des Eingangssignales IN, das untersucht wird.

Wenn man annimmt, daß die Frequenz des internen Taktsignales 100 MHz beträgt, ergibt sich für die Periodendauer des Taktsignals T_{int_clk} = 10 ns. Fmin soll beispielsweise 1 MHz und Fₘₐₓ 10 MHz betragen. Dadurch ergibt sich Tₘₐₓ = 1/Fₘₐₓ = 100 ns und Tₘᵢₙ = 1/Fₘᵢₙ = 1000 ns. In diesem Fall beträgt also n_{H} = 10 und n_{L} = 100.

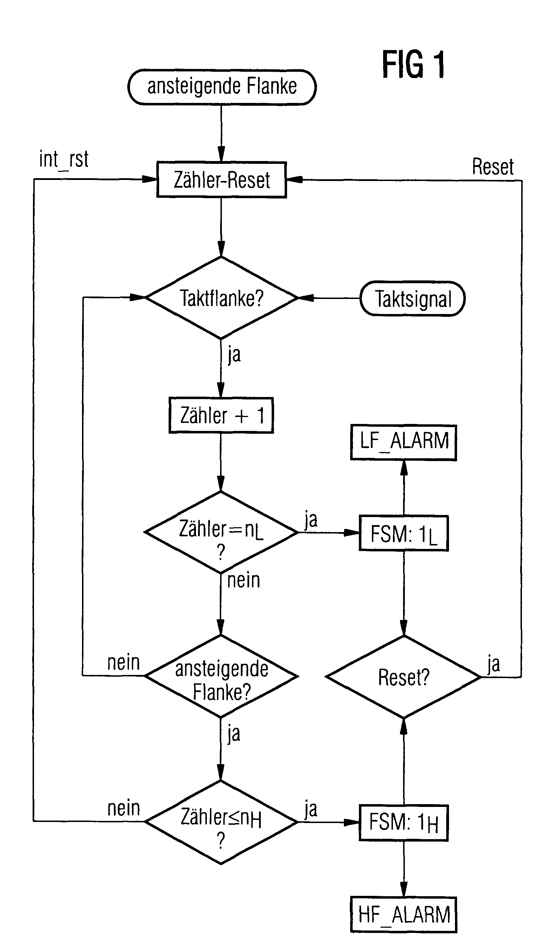

Zum Verständnis der Erfindung bietet es sich an, zunächst das erfindungsgemäße Verfahren gemäß der Figur 1 zu erläutern. Bei einer ansteigenden Flanke des Eingangssignales IN wird eine Zählvariable zurückgesetzt. Bei einer ansteigenden Flanke des Taktsignales int_clk wird die Zählvariable um 1 erhöht. Daraufhin wird die Zählvariable überprüft, ob sie den Wert n_{L} erreicht hat. Ist dies nicht der Fall und eine ansteigende Flanke wurde nicht detektiert, so wird mit dem Weiterzählen auf eine Flanke des Taktsignales int_clk hin fortgesetzt. Wenn die Zählvariable den Wert n_{L} erreicht, so bedeutet dies, daß die Periodendauer des Eingangssignales größer als Tₘᵢₙ ist. Die Frequenz ist damit kleiner als Fₘᵢₙ und ein erstes Ausgangssignal LF_Alarm wird ausgegeben. Wenn die Zählvariable noch nicht den Wert n_{L} erreicht hat, jedoch ein Flankenanstieg des Eingangssignales IN detektiert wurde, so wird die Zählvariable daraufhin überprüft, ob ihr Wert kleiner oder gleich n_{H} ist. Ist dies nicht der Fall, so liegt die Frequenz des Eingangssignales im zulässigen Bereich und der Zähler wird, da eine ansteigende Flanke detektiert wurde, zurückgesetzt. Ist die Zählervariable jedoch kleiner als n_{H}, so ist die Periodendauer des Eingangssignales IN zu klein und ein zweiten Ausgangssignal HF_Alarm wird ausgegeben. Durch ein Reset-Signal kann das Verfahren wieder von vorne beginnen.

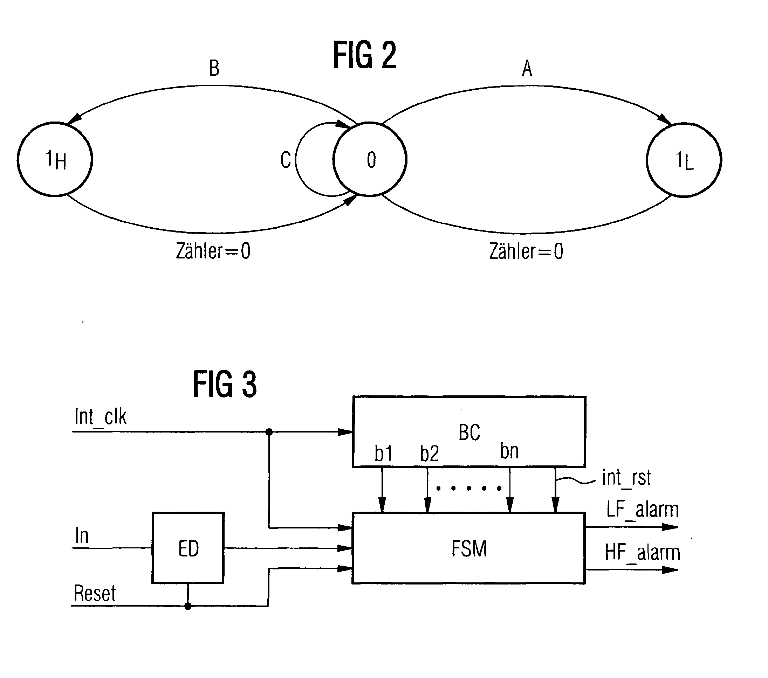

Figur 2 zeigt das zugehörige Zustandsdiagramm. Der Zustand "0" markiert den Normalzustand, wenn die Frequenz im zulässigen Bereich liegt. Die Bedingung A lautet "Zähler = n_{L}". Ist diese Bedingung erfüllt, so erfolgt ein Übergang in den Zustand 1_{L}, das heißt die Frequenz des Eingangssignales wurde als zu niedrig bewertet. Durch ein Reset-Signal wird der Zähler zurückgesetzt und es erfolgt ein Übergang in den Normalzustand "0". Die Bedingung B ist erfüllt, wenn die Zählvariable kleiner als n_{H} ist, wenn eine ansteigende Flanke detektiert wurde. Der Zustand 1_{H} zeigt an, daß die Frequenz des Eingangssignales zu groß ist. Durch einen zurückgesetzten Zähler gelangt man wiederum in den Normalzustand "0". Die Bedingung C ist erfüllt, wenn die Zählvariable kleiner als n_{L} ist und die Zählvariable bei Auftreten einer ansteigenden Flanke größer als n_{H} ist. Wenn keine ansteigende Flanke detektiert wurde, so genügt es, wenn die Zählvariable kleiner als n_{L} ist.

Ein Blockschaltbild einer erfindungsgemäßen Schaltungsanordnung, also eines Frequenzsensors, ist in der Figur 3 dargestellt. Ein interne Taktsignal int clk wirkt sowohl auf einen Zähler BC, der als n-bit-Zähler ausgeführt ist, und auf einen Zustandsspeicher FSM. Das Eingangssignal IN wirkt auf einen Flankendetektor ED, der bei Detektion einer ansteigenden Flanke ein Signal an den Zustandsspeicher FSM gibt. Ein Reset-Signal setzt den Flankendetektor ED sowie den Zustandsspeicher FSM zurück. Dieser wiederum wirkt über ein entsprechendes Signal int_rst auf den Zähler BC, um den Zähler zurückzusetzen. Der aktuelle Stand des Zählers wird dem Zustandsspeicher FSM übergeben.

Statt des n-bit-Zählers kann natürlich auch ein anderer Zählerbaustein verwendet werden. Die Zustände des Zustandsspeichers FSM werden in Form von zwei Ausgangssignalen angezeigt, nämlich durch das LF_Alarm- und das HF_Alarm-Signal. Die Logik der Anordnung kann so ausgelegt werden, daß der Frequenzsensor nur dann erneut beginnt zu messen, wenn ein Reset-Signal auf den entsprechenden Eingang des Frequenzsensors gegeben wird, oder aber nach einer gewissen Zeitspanne beginnt die Anordnung erneut die Frequenz zu überwachen, indem automatisch ein Reset-Signal generiert wird. Eine dritte Möglichkeit besteht darin, die Alarmanzeige zurückzusetzen, sobald in einer fortlaufenden Messung festgestellt wurde, daß die Frequenz nun wieder im zulässigen Bereich liegt. Die Ausgabe der Signale LF_Alarm und HF_Alarm hätten somit eine rein anzeigende Wirkung.

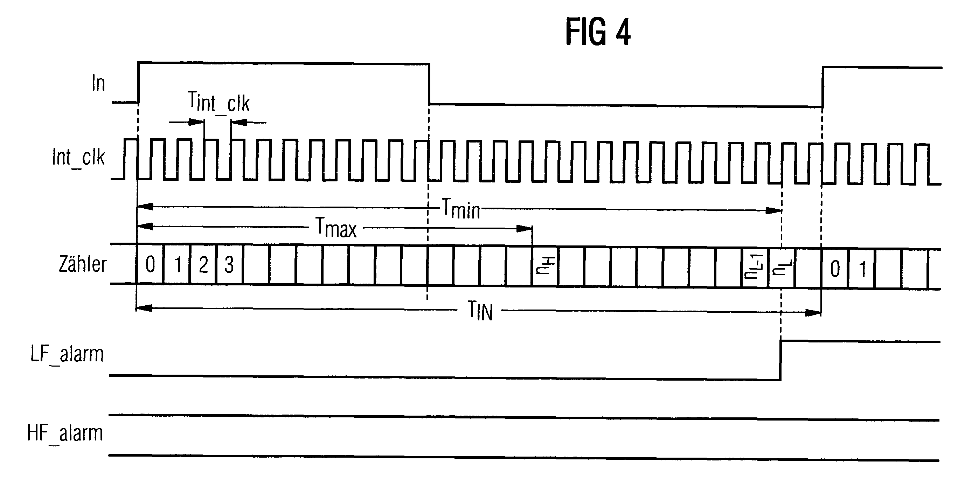

In der Figur 4 sind die Signalverläufe der Signale der Anordnung von Figur 3 angegeben. Im dargestellten Beispiel ist die Frequenz des Eingangssignales IN zu gering, das heißt die Periodendauer T_{IN} ist zu groß. Mit der ansteigenden Flanke des Eingangssignales IN wird der Zähler auf Null zurückgesetzt. Mit dem Taktsignal int_clk wird die Zählvariable nun so lange weitergezählt, bis sie den Wert n_{L} erreicht. Da bis zu diesem Zeitpunkt noch keine weitere ansteigende Flanke detektiert wurde und somit der Zähler nicht zurück gesetzt wurde, geht der Zustandsspeicher in den Zustand 1_{L} über und das Ausgangssignal LF_Alarm nimmt den HIGH-Pegel ein.

## Patentansprüche

1. Frequenzsensor für digitale Signale mit
- einem Flankendetektor (ED), dessen Eingang mit einem Anschluß für ein Filter-Eingangssignal (in) mit zwei möglichen Pegeln (L, H) verbunden ist,
- einem Zähler (BC), der Eingänge für ein Taktsignal (clk_int) und ein Resetsignal (int_rst) aufweist,
- einem drei Zustände (0, 1_{L}, 1_{H}) aufweisenden Zustandsspeicher (FSM), der mit dem Zähler (BC) und dem Ausgang des Flankendetektors verbunden ist, wobei durch die Zustände (0, 1_{L}, 1_{H}) des Zustandsspeichers (FSM) Ausgangssignale (LF_alarm, HF_alarm) des Filtersensors bestimmt sind,
wobei der Zustandspeicher (FSM)
- bei Erreichen eines ersten festlegbaren Wertes (n_{L}), der in Verbindung mit der Periodendauer des Taktsignals (int_clk) eine maximalen Pulsdauer (Tₘᵢₙ) beschreibt, einen eine Unterschreitung eines erlaubten Frequenzbereich markierenden Zustand (1_{L}) einnimmt,
- bei steigender/fallender Flanke des Eingangssignales (IN) und einem Zählerstand, der unterhalb eines zweiten festlegbaren Wertes (n_{H}) liegt, der in Verbindung mit der Periodendauer des Taktsignals eine minimale Pulsdauer (Tmax) beschreibt, einen eine Überschreitung des erlaubten Frequenzbereich markierenden Zustand (1_{H}) einnimmt und
- in anderen Fällen im neutralen Zustand (0) verleibt, und
wobei bei einer steigenden/fallenden Flanke ein Rücksetzsignal (int_rst) an dem Zähler anliegt.

2. Frequenzsensor nach Anspruch 1,
**dadurch gekennzeichnet, daß** die Frequenz des Taktsignales (int_clk) größer ist als die obere Frequenz (Fₘₐₓ) des erlaubten Frequenzbereiches.

3. Frequenzsensor nach Anspruch 2,
**dadurch gekennzeichnet, daß** Frequenz des Taktsignales (int_clk) mindestens zehnmal größer ist als die obere Frequenz (Fₘₐₓ) des erlaubten Frequenzbereiches.

4. Verfahren zur Frequenzüberwachung eines digitalen Signales bei dem
- eine Zählvariable bei einer ansteigenden Flanke eines Eingangssignales (IN) auf einen Startwert gesetzt wird und anschließend die Zählvariable durch ein vorgegebenes Taktsignal (int_clk) schrittweise erhöht/erniedrigt wird,
- bei Erreichen eines ersten festlegbaren Wertes (n_{L}) der Zählvariablen eine erste Ausgangsvariable (NF_ALARM) auf einen eine zu niedrige Frequenz des Eingangssignales (IN) markierenden Wert gesetzt wird,
- bei einer ansteigenden Flanke des Eingangssignales (IN) die erste oder eine zweite Ausgangsvariable (HF_ALARM) auf einen eine zu hohe Frequenz des Eingangssignales (IN) markierenden Wert gesetzt wird, wenn die Zählvariable kleiner als ein zweiter festlegbarer Wert ist (n_{H}), wobei der zweite festlegbare Wert (n_{H}) kleiner als der erste festlegbare Wert (n_{L}) ist.

5. Frequenzsensor nach Anspruch 4,
**dadurch gekennzeichnet, daß** die Frequenz des Taktsignales (int_clk) größer ist als die obere Frequenz (Fₘₐₓ) des erlaubten Frequenzbereiches.

6. Frequenzsensor nach Anspruch 5,
**dadurch gekennzeichnet, daß** Frequenz des Taktsignales (int_clk) mindestens zehnmal größer ist als die obere Frequenz (Fₘₐₓ) des erlaubten Frequenzbereiches.
